# EUROPEAN PATENT SPECIFICATION

(11) **EP 2 721 111 B1**
(45) Date of publication and mention of the grant of the patent: **15.05.2019**
(21) Application number: 12800067.6
(22) Date of filing: 03.07.2012
(51) Int. Cl.: C09K 5/14, C08K 3/04, H01L 33/64, H01L 23/373

(54) **THERMALLY CONDUCTIVE THERMOPLASTIC COMPOSITIONS**
WÄRMELEITENDE THERMOPLASTISCHE ZUSAMMENSETZUNGEN
COMPOSITIONS THERMOPLASTIQUES THERMOCONDUCTRICES

(30) Priority: 15.06.2011 US 201113160740
(43) Date of publication of application: 23.04.2014
(73) Proprietor: Covestro LLC, Pittsburgh, PA 15205 (US); Thermal Solution Resources, LLC, Narragansett, RI 02882 (US)
(72) Inventor: LI, Xiangyang, Seven Fields, PA 16046 (US); SAGAL, Mikhail, Wakefield, RI 02879 (US)
(74) Representative: Levpat
(86) International application number: PCT/US2012/045405
(87) International publication number: WO 2012/174574

(56) References cited:
- WO-A1-2009/115512
- FR-A1- 2 938 844
- US-A- 4 971 726
- US-A1- 2005 075 442
- US-A1- 2005 116 376
- US-A1- 2009 093 581
- US-A1- 2010 305 253
- US-A1- 2011 040 007
- DATABASE WPI Week 200726 Thomson Scientific, London, GB; AN 2007-260708 XP002733590, & JP 2007 016093 A (TEIJIN KASEI LTD) 25 January 2007 (2007-01-25)

## Description

### FIELD OF THE INVENTION

The present invention relates in general to plastics, and more specifically, to a thermally conductive thermoplastic composition.

### BACKGROUND OF THE INVENTION

Expanded graphite has been known in the art for some time. For example, Aylesworth, in U.S. Pat. Nos. 1,137,373 and 1,191,383, and Shane et al., in U.S. Pat. No. 3,404,061, all describe ways of making expanded graphite.

U.S. Pat. No. 3,416,992, issued to Amos, teaches compositions containing expanded graphite and plastic materials.

Hayward, in U.S. Pat. No. 5,882,570, Meza et al., in U.S. Pat. No. 6,620,359, and Hayward et al., in U.S. Pat. No. 6,746,626, all describe compositions containing expanded graphite and polymeric materials.

U.S. Pat. No. 7,235,918, issued to McCullough et al., provides a thermally-conductive polymer composition suitable for making molded reflector articles having light-reflecting surfaces. The composition contains: a) about 20% to about 80% by weight of a base polymer matrix, such as polycarbonate; and b) about 20% to about 80% by weight of a thermally-conductive carbon material, such as graphite. The composition is said to be useful in making reflector articles such as housings for automotive tail lamps, head lamps, and other lighting fixtures. A method for manufacturing reflector articles is also provided by McCullough et al.

Miller, in U.S. Published Patent Application No. 2005/0272845, describes an injection moldable, thermally conductive polymer composition said to have ultra low CTE properties and suitable both for substrate applications in high precision electronics assemblies as well as over molding applications in conjunction with ceramic substrates. The composition includes a base polymer matrix material loaded with thermally conductive filler, which is said to impart thermal conductivity to the polymer matrix while also maintaining or enhancing the dielectric properties of the base polymer. Miller says the resultant composition exhibits CTE properties in the range of between 9 ppm/°C and 2 ppm/°C, exhibits an optical anisotropy of below 1.5, and a thermal conductivity of greater than 2 W/m°K. The composition of Miller is said to be suitable for use in over molding applications in conjunction with virtually any suitable electronics substrate material without the introduction of mechanical stresses produced by large CTE differentials.

U.S. Published Patent Application No. 2010/0072416 in the name of Fujioka et al. describes a heat-dissipating resin composition that is said to be useful for forming a substrate for LED mounting or a reflector provided on the substrate for LED mounting and is excellent in heat dissipation, electrical insulation, heat resistance and light resistance while an LED element emits light, a substrate for LED mounting and a reflector comprising the composition. The composition of Fujioka et al. contains a thermoplastic resin such as modified polybutylene terephthalate and a thermally conductive filler consisting of scaly boron nitride or the like, and has thermal deformation temperature of 120°C or higher, a thermal conductivity of 2.0 W/(mK) or higher, and a thermal emissivity of 0.7 or higher.

Brown in U.S. Published Patent Application No. 2008/0287585 details thermally-conductive compositions and reaction tubes for chemical- and biochemical-based analytical processing. The compositions and reaction tubes contain at least one plastic and at least one compound having a higher thermal conductivity than the at least one plastic to result in compositions and tubes having increased thermal conductivity when compared to the at least one plastic alone. Such compositions and tubes are said to be capable of facilitating rapid heat transfer in numerous heat transfer applications. The thermally-conductive compositions and reaction tubes of Brown are said to be especially suitable for containing reaction constituents during thermal cycling of the polymerase chain reaction (PCR).

PCT Published Patent Application No. WO 2010/061129 in the name of Dufaure et al. discloses an expanded graphite, in which the specific surface is between 15 and 30 m2/g, the apparent density is less than 0.1 g/cm3, for an average particle size of more than 15 µm, to grant a thermoplastic polymer properties of thermal, electric and rheological conductivity suitable for the transformation of said polymer.

Janssen et al., in PCT Published Patent Application No. WO 2009/115512, describe a heatsink for an electrical or electronic device comprising a plastic body made of a thermally conductive plastic material comprising of an expanded graphite in an amount of at least 20 wt.%, relative to the total weight of the thermally conductive plastic material.

PCT Published Patent Application No. WO 2011/013645 in the name of Takeuchi et al. describes polycarbonate resin composition which contains, per 100 parts by mass of (A) a polycarbonate resin, 30-100 parts by mass of (B) artificial graphite, 0.01-5 parts by mass of (C) an organopolysiloxane that has a group selected from among a phenyl group, a methoxy group and a vinyl group, and 0.01-5 parts by mass of (D) a fluorine compound. Also disclosed are: a molded body which is obtained by molding the polycarbonate resin composition; and a component for an electrical/electronic device, a case for an electrical/electronic device and a chassis for an electrical/electronic device, each comprising the molded body. The polycarbonate resin composition provides a molded article which is said to have high thermal conductivity and high mechanical strength, while exhibiting high flame retardancy even in cases when the molded article is formed thin.

Maruyama et al., in JP 2009-161582, provide a conductive polycarbonate resin composition said to have excellent antistaticity, electromagnetic wave-shielding property, mechanical strengths, thermal stability, and appearance. The polycarbonate resin composition contains (A) 50 to 90 wt.% of a polycarbonate resin and (B) 50 to 10 wt.% of graphite, wherein the concentration of silicon in the graphite (B) is ≤ 1,000 ppm.

The above cited references teach, in general, that thermally conductive fillers are added to thermoplastic resin to make the resultant composite thermally conductive. These thermally conductive fillers can be carbon based, such as carbon fibers, graphites, and carbon black. They can be ceramic-based, such as boron nitride, aluminum carbide. However, as the reported thermal conductivities are low, a need continues to exist in the art for a high thermally conductive thermoplastic composition.

### SUMMARY OF THE INVENTION

Accordingly, the present invention provides such a composition containing an expanded graphite with a set of unique attributes resulting in high thermal conductivity. The present invention provides a composition containing 90 wt.-% to 30 wt.-% of at least one amorphous thermoplastic selected from the group consisting of polycarbonate and polymethylmethacrylate (PMMA) and 10 wt.-% to 70 wt.-% of expanded graphite, wherein 90% of the particles of the expanded graphite have a particle size of at least 200 microns. The composition is free of of polytetrafluoroethylene (PTFE) and of potassium perfluorobutane sulphonate.

The inventive compositions may find use in LED heat sink applications.

These and other advantages and benefits of the present invention will be apparent from the Detailed Description of the Invention herein below.

### DETAILED DESCRIPTION OF THE INVENTION

The present invention will now be described for purposes of illustration and not limitation.

The present invention provides a composition containing 90 wt.-% to 30 wt.-% of at least one amorphous thermoplastic and 10 wt.-% to 70 wt.-% of expanded graphite, wherein 90 wt.-% of the particles of the expanded graphite have a particle size of at least 200 microns.

Polycarbonate is particularly preferred as amorphous thermoplastic.

Suitable polycarbonate resins for preparing the composition of the present invention are homopolycarbonates and copolycarbonates, both linear or branched resins and mixtures thereof. As used herein, the term "polycarbonate" includes homopolycarbonates such as BPA polycarbonate, copolycarbonates derived from two or more different dihydric phenols, and copolyestercarbonates which include structural units derived from one or more dihydric phenols and one or more diacid derived structural units. The diacid, for example, includes dodecandioic acid, terephthalic acid, isophthalic acid. U.S. Pat. No. 4,983,706 describes a method for making copolyestercarbonate.

The polycarbonates have a weight average molecular weight of preferably 10,000 to 200,000, more preferably 20,000 to 80,000 and their melt flow rate, per ASTM D-1238 at 300°C and 1.2 kg weight, is preferably 1 to 80 g/10 min., more preferably 20 to 65 g/10 min. They may be prepared, for example, by the known diphasic interface process from a carbonic acid derivative such as phosgene and dihydroxy compounds by polycondensation (See, German Offenlegungsschriften 2,063,050; 2,063,052; 1,570,703; 2,211,956; 2,211,957 and 2,248,817; French Patent 1,561,518; and the monograph by H. Schnell, "Chemistry and Physics of Polycarbonates", Interscience Publishers, New York, New York, 1964).

In the present context, dihydroxy compounds suitable for the preparation of the polycarbonates of the invention conform to the structural formulae (1) or (2) below. 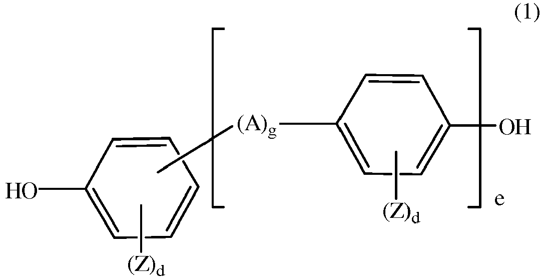 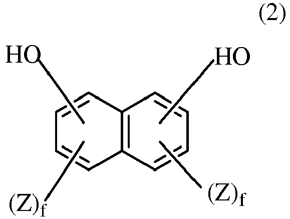 wherein
- A: denotes an alkylene group with 1 to 8 carbon atoms, an alkylidene group with 2 to 8 carbon atoms, a cycloalkylene group with 5 to 15 carbon atoms, a cycloalkylidene group with 5 to 15 carbon atoms, a carbonyl 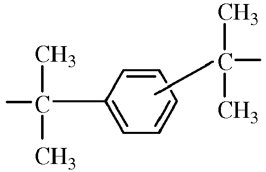 group, an oxygen atom, a sulfur atom, -SO- or -SO2 or a radical conforming to
- e and g: both denote the number 0 to 1;
- Z: denotes F, Cl, Br or C1-C4-alkyl and if several Z radicals are substituents in one aryl radical, they may be identical or different from one another;
- d: denotes an integer of from 0 to 4; and
- f: denotes an integer of from 0 to 3.

Among the dihydroxy compounds useful in the practice of the invention are hydroquinone, resorcinol, bis-(hydroxyphenyl)-alkanes, bis-(hydroxy-phenyl)-ethers, bis-(hydroxyphenyl)-ketones, bis-(hydroxy-phenyl)-sulfoxides, bis-(hydroxyphenyl)-sulfides, bis-(hydroxyphenyl)-sulfones, and α,α-bis-(hydroxyphenyl)-diisopropylbenzenes, as well as their nuclear-alkylated compounds. These and further suitable aromatic dihydroxy compounds are described, for example, in U.S. Pat. Nos. 5,401,826, 5,105,004; 5,126,428; 5,109,076; 5,104,723; 5,086,157; 3,028,356; 2,999,835; 3,148,172; 2,991,273; 3,271,367; and 2,999,846, the contents of which are incorporated herein by reference.

Further examples of suitable bisphenols are 2,2-bis-(4-hydroxyphenyl)-propane (bisphenol A), 2,4-bis-(4-hydroxyphenyl)-2-methyl-butane, 1,1-bis-(4-hydroxyphenyl)-cyclohexane, α,α'-bis-(4-hydroxy-phenyl)-p-diisopropylbenzene, 2,2-bis-(3-methyl-4-hydroxyphenyl)-propane, 2,2-bis-(3-chloro-4-hydroxyphenyl)-propane, 4,4'-dihydroxy- diphenyl, bis-(3,5-dimethyl-4-hydroxyphenyl)-methane, 2,2-bis-(3,5-dimethyl-4-hydroxyphenyl)-propane, bis-(3,5-dimethyl-4-hydroxyphenyl)-sulfide, bis-(3,5-dimethyl-4-hydroxy-phenyl)-sulfoxide, bis-(3,5-dimethyl-4-hydroxyphenyl)-sulfone, dihydroxy-benzophenone, 2,4-bis-(3,5-dimethyl-4-hydroxyphenyl)-cyclohexane, α,α'-bis-(3,5-dimethyl-4-hydroxyphenyl)-p-diisopropyl-benzene and 4,4'-sulfonyl diphenol.

Examples of particularly preferred aromatic bisphenols are 2,2-bis- (4-hydroxyphenyl)-propane, 2,2-bis-(3,5-dimethyl-4-hydroxyphenyl)-propane, 1,1-bis-(4-hydroxyphenyl)-cyclohexane and 1,1-bis-(4-hydroxy-phenyl)-3,3,5-trimethylcyclohexane. The most preferred bisphenol is 2,2-bis-(4-hydroxyphenyl)-propane (bisphenol A).

The polycarbonates useful in the invention may entail in their structure units derived from one or more of the suitable bisphenols.

Among those resins suitable in the practice of the invention are phenolphthalein-based polycarbonate, copolycarbonates and terpoly-carbonates such as are described in U.S. Pat. Nos. 3,036,036 and 4,210,741.

The polycarbonates useful in the present invention may also be branched by condensing therein small quantities, e.g., 0.05 to 2.0 mol % (relative to the bisphenols) of polyhydroxyl compounds. Polycarbonates of this type have been described, for example, in German Offenlegungsschriften 1,570,533; 2,116,974 and 2,113,374; British Patents 885,442 and 1,079,821 and U.S. Pat. No. 3,544,514. The following are some examples of polyhydroxyl compounds which may be used for this purpose: phloroglucinol; 4,6-dimethyl-2,4,6-tri-(4-hydroxy-phenyl)-heptane; 1,3,5-tri-(4-hydroxyphenyl)-benzene; 1,1,1-tri-(4-hydroxyphenyl)-ethane; tri-(4-hydroxyphenyl)-phenyl-methane; 2,2-bis-[4,4-(4,4'-dihydroxydiphenyl)]-cyclohexyl-propane; 2,4-bis-(4-hydroxy-1-isopropylidine)-phenol; 2,6-bis-(2'-dihydroxy-5'-methylbenzyl)-4-methyl-phenol; 2,4-dihydroxybenzoic acid; 2-(4-hydroxy-phenyl)-2-(2,4-dihydroxy-phenyl)-propane and 1,4-bis-(4,4'-dihydroxytri-phenylmethyl)-benzene. Some of the other polyfunctional compounds are 2,4-dihydroxy-benzoic acid, trimesic acid, cyanuric chloride and 3,3-bis-(4-hydroxyphenyl)-2-oxo-2,3-dihydroindole.

In addition to the polycondensation process mentioned above, other processes for the preparation of the polycarbonates of the invention are polycondensation in a homogeneous phase and transesterification. The suitable processes are disclosed in U.S. Pat. Nos. 3,028,365; 2,999,846; 3,153,008; and 2,991,273.

The preferred process for the preparation of polycarbonates is the interfacial polycondensation process. Other methods of synthesis in forming the polycarbonates of the invention, such as disclosed in U.S. Pat. No. 3,912,688, may be used. Suitable polycarbonate resins are available in commerce, for instance, from Bayer MaterialScience LLC under the MAKROLON trademark.

The term polyester as used herein is meant to include homo-polyesters and co-polyesters resins. These are resins the molecular structure of which include at least one bond derived from a carboxylic acid, preferably excluding linkages derived from carbonic acid. These are known resins and may be prepared through condensation or ester interchange polymerization of the diol component with the diacid according to known methods. Suitable resins include poly(alkylene dicarboxylates), especially poly(ethylene terephthalate) (PET), poly(1,4-butylene terephthalate) (PBT), poly(trimethylene terephthalate) (PTT), poly(ethylene naphthalate) (PEN), poly(butylenes naphthalate) (PBN), poly(cyclohexanedimethanol terephthalate) (PCT), poly(cyclohexanedimethanol-co-ethylene terephthalate) (PETG or PCTG), and poly(1,4-cyclohexanedimethyl-1,4-cyclohexanedicarboxylate) (PCCD).

U.S. Patents 2,465,319, 3,953,394 and 3,047,539 - disclose suitable methods for preparing such resins. The suitable polyalkylene terephthalates are characterized by an intrinsic viscosity of at least 0.2 and preferably about at least 0.4 deciliter/gram as measured by the relative viscosity of an 8% solution in orthochlorophenol at about 25°C. The upper limit is not critical but it preferably does not exceed about 2.5 deciliters/gram. Especially preferred polyalkylene terephthalates are those with an intrinsic viscosity in the range of 0.4 to 1.3 deciliter/gram.

The alkylene units of the polyalkylene terephthalates which are suitable for use in the present invention contain from 2 to 5, preferably 2 to 4 carbon atoms. Polybutylene terephthalate (prepared from 1,4-butanediol) and polyethylene terephthalate are the preferred polyalkylene tetraphthalates for use in the present invention. Other suitable polyalkylene terephthalates include polypropylene terephthalate, polyisobutylene terephthalate, polypentyl terephthalate, polyisopentyl terephthalate, and polyneopentyl terephthalate. The alkylene units may be straight chains or branched chains.

The preferred polyalkylene terephthalates may contain, in addition to terephthalic acid groups, up to 20 mol% of groups from other aromatic dicarboxylic acids with 8 to 14 carbon atoms or aliphatic dicarboxylic acids with 4 to 12 carbon atoms, such as groups from phthalic acid, isophthalic acid, naphthalene-2,6-dicarboxylic acid, 4,4'-di-phenyl-dicarboxylic acid, succinic, adipic, sebacic, azelaic acids or cyclohexanediacetic acid.

The preferred polyalkylene terephthalates may contain, in addition to ethylene glycol or butanediol-1,4-groups, up to 20 mol% of other aliphatic diols with 3 to 12 carbon atoms or cycloaliphatic diols with 6 to 21 carbon atoms, e.g., groups from propanediol-1,3, 2-ethylpropanediol-1,3, neopentyl glycol, pentanediol-1,5, hexanediol-1,6, cyclohexane-dimethanol-1,4, 3-methylpentanediol-2,4, 2-methyl-pentanediol-2,4, 2,2,4-trimethylpentanediol-1,3, and -1,6, 2-ethylhexanediol-1,3, 2,2-diethylpropanediol-1,3, hexanediol-2,5, 1,4-di-(β-hydroxyethoxy)-benzene, 2,2-bis-(4-hydroxycyclohexyl)-propane, 2,4-dihydroxy-1,1,3,3-tetra-methyl-cyclobutane, 2,2-bis-(3-β-bydroxyethoxyphenyl)-propane and 2,2-bis- (4-hydroxypropoxyphenyl) -propane (DE-OS 24 07 674, 24 07 776, 27 15 932).

The polyalkylene terephthalates may be branched by incorporating relatively small amounts of 3- or 4-hydric alcohols or 3- or 4-basic carboxylic acids, such as are described, for example, in DE-OS 19 00 270 and U.S. Pat. No. 3 692 744. Examples of preferred branching agents comprise trimesic acid, trimellitic acid, trimethylol-ethane and -propane and pentaerythritol. Preferably no more than 1 mol% of branching agent, with respect to the acid component, is used.

Polyalkylene terephthalates prepared solely from terephthalic acid and its reactive derivatives (e.g. its diallyl etsers) and ethylene glycol and/or butanediol-1,4 (polyethyleneterephthalate and polybutyleneterephthalate) and mixtures of these polyalkylene terephthalates are particularly preferred.

Suitable polyalkylene terephthalates have been disclosed in U.S. Patents 4,267,096; 4,786,692; 4,352,907; 4,391,954; 4,125,571; 4,125,572; and 4,188,314, 5,407,994.

The at least one amorphous thermoplastic is present in an amount ranging from 90 wt.-% to 30 wt.-% of the composition of the present invention, more preferably from 80 wt.-% to 40 wt.-% and most preferably from 70 wt.-% to 50 wt.-%. The at least one amorphous thermoplastic may be present in the composition of the present invention in an amount ranging between any combination of these values, inclusive of the recited values.

Semicrystalline thermoplastics and methods of their production are known to those skilled in the art. Preferred semicrystalline thermoplastics for use in the inventive composition include, but are not limited to, polyethylene (PE), polypropylene (PP), polybutylene terephthalate (PBT) and polyethylene terephthalate (PET), polyphenylene sulfide (PPS), polyphenylene either (PPO), liquid crystalline polymers (LCPs), and polyamide.

Amorphous and semicrystalline thermoplastics can be blended as resin composition in the present invention. Examples of blends of amorphous and semicrystalline thermoplastics are well known to those skilled in the art. Some examples of such blends are polycarbonate and PET, polycarbonate and PBT, polycarbonate and PPS, polycarbonate and LCPs. Some of these blends are commercially available from Bayer MaterialScience LLC under the trade name MAKROBLEND. There is no limitation on what kind of amorphous thermoplastic to blend with what kind of semicrystalline thermoplastic as long as the resulted blend serves the intended application.

Expanded graphite and methods of its production are known to those skilled in the art. Expanded graphite useful is present in an amount ranging from 10 wt.-% to 70 wt.-% of the composition of the present invention, more preferably from 20 wt.-% to 60 wt.-% and most preferably from 30 wt.-% to 50 wt.-%. The expanded graphite may be present in the composition of the present invention in an amount ranging between any combination of these values, inclusive of the recited values. The present inventors have found that at least 90% of the particles of the expanded graphite should have a particle size of at least 200 microns.

The inventive composition may further include effective amounts of any of the additives known for their function in the context of thermoplastic molding compositions. These include any one or more of lubricants, mold release agents, for example pentaerythritol tetrastearate, nucleating agents, antistatic agents, other antioxidants, thermal stabilizers, light stabilizers, hydrolytic stabilizers, impact modifiers, fillers and reinforcing agents, colorants or pigments, as well as further flame retarding agents, other drip suppressants or a flame retarding synergists. The additives may be used in effective amounts, preferably of from 0.01 to a total of 30% relative to the total weight of the polycarbonate component.

The inventive composition may be produced by conventional procedures using conventional equipment. It may be used to produce moldings of any kind by thermoplastic processes such as injection molding, extrusion and blow molding methods. The Examples which follow are illustrative of the invention.

### EXAMPLES

The present invention is further illustrated, but is not to be limited, by the following examples. All quantities given in "parts" and "percents" are understood to be by weight, unless otherwise indicated.

In preparing the compositions shown below the following components were used:

| | |
|---|---|
| POLYCARBONATE | PCFS2000P, a homopolycarbonate from Bayer MaterialScience LLC, with a melt flow rate of about 65 g/10 minute under 300oC and 1.2 Kg condition; |
| PET | polyethylene terephthalate, commercially available as PET 8944, from Invista with an intrinsic viscosity about 0.58 dL/gram; |
| EXPANDED GRAPHITE A | expanded graphite with the following attributes: at least 98% carbon, density 2.25 g/cm3, more than 90% of the particles are ∼ 250 micron and above: about 50% of the particles are 710 micron or greater; about 27% of the particles are 1 mm or greater, but no more than 3 mm. The particle size is determined by sieve analysis, commercially available as CONDUCTOGRAPH GFG500 or ECOPHIT GFG500 from SGL Group; |
| SYNTHETIC GRAPHITE B | synthetic graphite flakes with the following attributes: at least 98% carbon, 90% of the particles are less than 51 micron, and 50% of the particles are less than 23 micron. Particle size was determined by laser diffraction method. Commercially available as ASBURY A99 from Asbury Carbons; |
| EXPANDED GRAPHITE C | expanded graphite with the following attributes: at least 99% carbon. 90% of the particles arc less than 94 micron and 50% of the particles are less than 43 micron. The particle size is determined by laser diffraction method, commercially available as C-THERM001 from Timcal Graphite and Carbon; |
| FLAME RETARDANT A | potassium perfluorobutane sulfonate, commercially available as BAYOWET C4 TP AC 2001, from Lanxess AG; and |
| FLAME RETARDANT B | encapsulated polytetrafluoroethylene (PTFE) with styrene acrylonitrile (SAN), commercially available as BLENDEX 449 from Artek Surfin Chemicals, Ltd. |

In the preparation of the exemplified compositions, the components and additives were melt compounded in a twin screw extruder ZSK 30 at a temperature profile of 150 to 350oC. Graphite was fed through a side feeder downstream, whereas polycarbonate and other additives were fed through a main feeder upstream at zone 1. Pellets thus produced were dried in a forced air convection oven at 120oC. Disks and flame bars were made by injection molding at melt temperature of about 350oC and mold temperature around 95oC.

Disks with diameter of 50 mm and thickness 3.2 mm were used to measure thermal conductivity in the flow direction by Hot Disk Transient Plane Source (TPS) method which is often referred to as " The Gustafsson Probe". This TPS method meets ISO standard ISO-DIS22007-2.2.

The flammability rating was determined according to UL-94 V on specimens having the indicated thickness

### Examples 1-7

**Table I**

| Component | Ex. 1 | Ex. 2 | Ex. 3 | Ex. 4 | Ex. 5 | Ex. 6 | Ex. 7 |
|---|---|---|---|---|---|---|---|
| POLYCARBONATE | 55 | 50 | 40 | 55 | 50 | 40 | 55 |
| EXPANDED GRAPHITE A | 45 | 50 | 60 | | | | |
| EXPANDED GRAPHITE B | | | | 45 | 50 | 60 | |
| EXPANDED GRAPHITE C | | | | | | | 45 |
| Thermal conductivity w/K-m | 28.3 | 33.1 | 51.9 | 9.1 | 9.3 | 17.1 | 18.5 |
| UL94-V, 1.5 mm | V0 | | | failure | | | failure |

Table I summarizes the results of the above-detailed examples. The superiority of the inventive polycarbonate composition made with EXPANDED GRAPHITE A in terms of thermal conductivity and flammability rating is apparent by reference to Table I.

### Reference examples 8-11

**Table II**

| Component | Ex. 8 | Ex. 9 | Ex. 10 | Ex. 11 |
|---|---|---|---|---|
| PET | 55 | 50 | 55 | 55 |
| EXPANDED GRAPHITE A | 45 | 50 | | |
| EXPANDED GRAPHITE B | | | 45 | |
| EXPANDED GRAPHITE C | | | | 45 |
| Thermal conductivity (w/K-m) | 39.9 | 50.4 | 12.5 | 25.4 |

Table II summarizes the results of the above-detailed examples. The superiority of the polyethylene terephthalate (PET) composition made with EXPANDED GRAPHITE A in terms of thermal conductivity is apparent by reference to Table II.

### Examples 12-14

**Table III**

| Component | Ex. 12 | Ex. 13 | Ex. 14 |
|---|---|---|---|
| POLYCARBONATE | 55 | 55 | 55 |
| EXPANDED GRAPHITE A | 45 | 45 | 45 |
| FLAME RETARDANT A | | 0.2 | |
| FLAME RETARDANT B | | | 0.5 |
| UL94-V, 1.5 mm | V0 | failure | failure |

Table III demonstrates the compositions containing EXPANDED GRAPHITE A should exclude flame retardant additives such as polytetrafluoroethylene (PTFE) and potassium perfluorobutane sulphonate.

## Claims

1. A composition comprising:
90 wt.-% to 30 wt.-% of at least one amorphous thermoplastic, wherein the amorphous thermoplastic is selected from the group consisting of polycarbonate and polymethylmethacrylate (PMMA); and
10 wt.-% to 70 wt.-% of expanded graphite,
wherein 90% of the particles of the expanded graphite have a particle size of at least 200 microns, wherein the particle size is determined by sieve analysis, and
wherein the composition is free of polytetrafluoroethylene (PTFE) and of potassium perfluorobutane sulphonate.

2. A composition according to claim 1, wherein the composition comprises 20 to 60 wt.-% expanded graphite.

3. A composition according to claim 1, wherein the composition comprises 30 to 50 wt.-% expanded graphite.

4. A light emitting diode (LED) heat sink comprising the composition according to one of the preceding claims.

## Patentansprüche

1. Zusammensetzung, umfassend:
90 Gew.-% bis 30 Gew.-% mindestens eines amorphen Thermoplasts, wobei der amorphe Thermoplast aus der Gruppe bestehend aus Polycarbonat und Polymethylmethacrylat (PMMA) ausgewählt ist; und
10 Gew.-% bis 70 Gew.-% Blähgraphit,
wobei 90 % der Teilchen des Blähgraphits eine Teilchengröße von mindestens 200 Mikron aufweisen, wobei die Teilchengröße durch Siebanalyse bestimmt wird, und
wobei die Zusammensetzung frei von Polytetrafluorethylen (PTFE) und von Kaliumperfluorbutansulfonat ist.

2. Zusammensetzung nach Anspruch 1, wobei die Zusammensetzung 20 bis 60 Gew.-% Blähgraphit umfasst.

3. Zusammensetzung nach Anspruch 1, wobei die Zusammensetzung 30 bis 50 Gew.-% Blähgraphit umfasst.

4. Wärmesenke für eine Leuchtdiode (LED), umfassend die Zusammensetzung nach einem der vorhergehenden Ansprüche.

## Revendications

1. Composition comprenant :
90% en poids jusqu'à 30% en poids d'au moins un thermoplastique amorphe, le thermoplastique amorphe étant choisi dans le groupe constitué par un polycarbonate et un poly(méthacrylate de méthyle) (PMMA) ; et
10% en poids jusqu'à 70% en poids de graphite expansé,
90% des particules de graphite expansé possédant une grosseur de particule d'au moins 200 microns, la grosseur de particule étant déterminée par analyse par tamisage et la composition étant exempte de polytétrafluoroéthylène (PTFE) et exempte de perfluorobutanesulfonate de potassium.

2. Composition selon la revendication 1, la composition comprenant 20 jusqu'à 60% en poids de graphite expansé.

3. Composition selon la revendication 1, la composition comprenant 30 jusqu'à 50% en poids de graphite expansé.

4. Dissipateur thermique de diode électroluminescente (LED) comprenant la composition selon l'une quelconque des revendications précédentes.
